# EUROPEAN PATENT APPLICATION

(11) **EP 4 216 264 A1**
(43) Date of publication of application: **26.07.2023**
(21) Application number: 23151728.5
(22) Date of filing: 16.01.2023
(51) Int. Cl.: H01L 23/00

(54) **THICK BONDING PAD STRUCTURE FOR WIRE BOND STRESS REDUCTION**

(30) Priority: 25.01.2022 US 202263302612 P; 12.12.2022 US 202218079610
(71) Applicant: STMicroelectronics Pte Ltd., Singapore 569508 (SG)
(72) Inventor: YIM, Churn Weng, 822211 SINGAPORE (SG); CASTORINA, Maurizio Gabriele, 328626 SINGAPORE (SG); NGWAN, Voon Cheng, 732686 SINGAPORE (SG); YONG, Yean Ching, 550537 SINGAPORE (SG); ADNAN, Ditto, 821173 SINGAPORE (SG); TAHIR, Fadhillawati, 644271 SINGAPORE (SG)
(74) Representative: Cabinet Beaumont

(57) **Abstract**

A bonding pad for an integrated circuit is formed by a stack of bonding pad layers. A lower bonding pad layer is supported by a bonding pad support layer. A passivation layer extends over the lower bonding pad layer and includes a passivation opening at a portion of an upper surface of the lower bonding pad layer. An upper bonding pad layer rests on said passivation layer and in the passivation opening in contact with the lower bonding pad layer.

## Description

### TECHNICAL FIELD

The present invention generally relates to an integrated circuit and, in particular, to a bonding pad structure for an integrated circuit.

### BACKGROUND

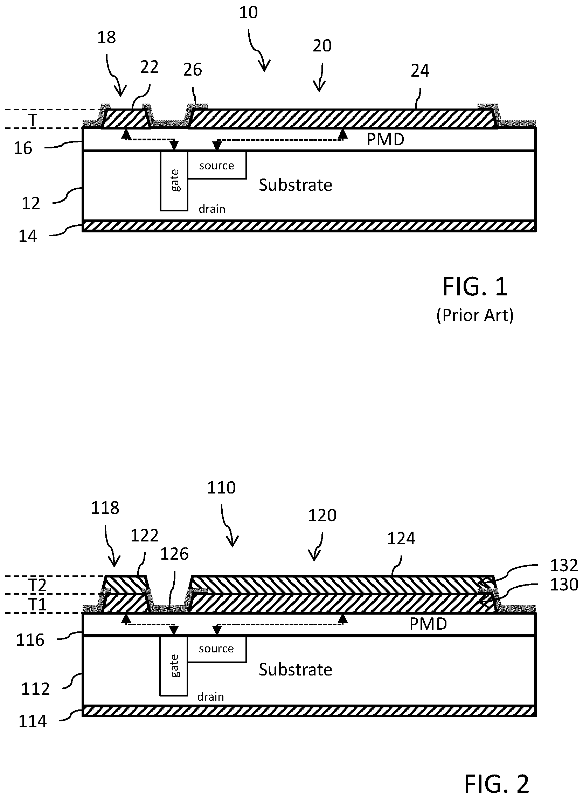

Figure 1 shows a cross-sectional view of a conventional integrated circuit 10 which includes a semiconductor substrate 12 in and on which are formed an integrated circuit device. As an example, the integrated circuit device may comprise a vertically conducting power MOSFET device where a drain electrode 14 of the transistor is provided at the back side of the semiconductor substrate 12, a vertical gate is provided in the semiconductor substrate 12 and a doped source region is provided at an upper surface of the semiconductor substrate 12. A premetallization dielectric (PMD) layer 16 covers semiconductor substrate 12. Bonding pads 18 and 20 are provided above the premetallization dielectric layer 16 for the gate electrode 22 (electrically coupled to the vertical gate) and source electrode 24 (electrically coupled to the source region), respectively, of the transistor. A passivation layer 26 covers the bonding pads 18 and 20, as well as the upper surface of the premetallization dielectric layer 16, and includes openings for accessing the gate and source electrodes 22 and 24.

Wire bonding to the bonding pads 18 and 20 is a high stress activity which can result in the cracking of, or damage to, the bonding pad and/or the underlying premetallization dielectric layer 16 and/or semiconductor substrate 12. One solution to this problem is to increase the thickness T of the bonding pads 18 and 20. For example, a conventional AlCu process for bonding pad formation has a thickness in a range of 4-5.5 µm. There would be an advantage if bonding pads with thicknesses in a range of 8.5-9.5 µm, for example, could be produced. However, obtaining such a thicker bonding pad using typical fabrication processes requires the use of a correspondingly thicker resist (for example, with a thickness greater than 9 µm) in order to etch the openings in the passivation layer. Such a thicker resist is not currently available and/or is not supported in typical semiconductor processes.

There is accordingly a need in the art to address the foregoing problem and produce a bonding pad having a thickness in a range of 8.5-9.5 µm using typical semiconductor processes.

### SUMMARY

In an embodiment, a method comprises: depositing a first metal layer over a bonding pad support layer; patterning the first metal layer to define a lower bonding pad layer; conformally depositing a passivation layer over the lower bonding pad layer; forming a passivation opening in the passivation layer to expose a portion of an upper surface of the lower bonding pad layer; conformally depositing a second metal layer over the passivation layer and on the upper surface of the lower bonding pad layer in the passivation opening; and patterning the second metal layer to define an upper bonding pad layer; wherein said upper and lower bonding pad layers form a bonding pad for an integrated circuit.

In an embodiment, an integrated circuit comprises: a bonding pad support layer; a lower bonding pad layer over the bonding pad support layer; a passivation layer over the lower bonding pad layer; wherein said passivation layer includes a passivation opening at a portion of an upper surface of the lower bonding pad layer; an upper bonding pad layer on said passivation layer and in said passivation opening in contact with the lower bonding pad layer; wherein said upper and lower bonding pad layers form a bonding pad for said integrated circuit.

One embodiment provides a method, comprising:
depositing a first metal layer over a bonding pad support layer;
patterning the first metal layer to define a lower bonding pad layer;
conformally depositing a passivation layer over the lower bonding pad layer;
forming a passivation opening in the passivation layer to expose a portion of an upper surface of the lower bonding pad layer;
conformally depositing a second metal layer over the passivation layer and in contact with the upper surface of the lower bonding pad layer in the passivation opening; and
patterning the second metal layer to define an upper bonding pad layer;
wherein said upper and lower bonding pad layers form a bonding pad for an integrated circuit..

According to an embodiment, the bonding pad support layer comprises a premetallization dielectric layer.

According to an embodiment, the bonding pad support layer comprises an upper most interconnect layer.

According to an embodiment, the passivation layer comprises a nitride layer.

According to an embodiment, the passivation layer comprises a Tetraethyl orthosilicate (TEOS) layer.

According to an embodiment, the passivation layer comprises stack including a nitride layer and a Tetraethyl orthosilicate (TEOS) layer.

According to an embodiment, the method further comprises, after forming the passivation opening and before conformally depositing the second metal layer, performing an Argon sputter to pre-condition the upper surface of the lower bonding pad layer in the passivation opening.

According to an embodiment, pre-conditioning the upper surface removes metal oxide from the upper surface.

According to an embodiment, conformally depositing the second metal layer is performed in the absence of a sputter etch.

According to an embodiment, the method further comprises providing a further passivation layer on the upper bonding pad layer.

According to an embodiment, patterning the first metal layer comprises performing a dry etching.

According to an embodiment, patterning the second metal layer comprises performing a wet etching.

According to an embodiment, a thickness of the lower bonding pad layer is in a range of 4-5 µm and wherein a thickness of the upper bonding pad layer is in a range of 4-5 µm.

According to an embodiment, a lateral dimension of the upper bonding pad layer is smaller than a corresponding lateral dimension of the lower bonding pad layer.

According to an embodiment, a lateral dimension of the upper bonding pad layer is larger than a corresponding lateral dimension of the lower bonding pad layer and wherein a lateral side edge of the upper bonding pad layer is aligned with a lateral side edge of the passivation layer.

According to an embodiment, forming the passivation opening comprises:
depositing a resist layer having a thickness that is greater than a thickness of the lower bonding pad layer;
forming an opening in the resist layer to form a mask; and
performing an etch of the passivation layer through the opening in the resist layer to provide the passivation opening.

One embodiment provides an integrated circuit, comprising:
a bonding pad support layer;
a lower bonding pad layer over the bonding pad support layer;
a passivation layer over the lower bonding pad layer;
   wherein said passivation layer includes a passivation opening at a portion of an upper surface of the lower bonding pad layer;
an upper bonding pad layer on said passivation layer and in said passivation opening in contact with the lower bonding pad layer;
   wherein said upper and lower bonding pad layers are in direct contact and form a bonding pad for said integrated circuit.

According to an embodiment, the bonding pad support layer comprises a premetallization dielectric layer.

According to an embodiment, the bonding pad support layer comprises an upper most interconnect layer.

According to an embodiment, the passivation layer comprises a nitride layer.

According to an embodiment, the passivation layer comprises a Tetraethyl orthosilicate (TEOS) layer.

According to an embodiment, the passivation layer comprises stack including a nitride layer and a Tetraethyl orthosilicate (TEOS) layer.

According to an embodiment, the circuit further comprises a further passivation layer on the upper bonding pad layer.

According to an embodiment, a thickness of the lower bonding pad layer is in a range of 4-5 µm and wherein a thickness of the upper bonding pad layer is in a range of 4-5 µm.

According to an embodiment, a lateral dimension of the upper bonding pad layer is smaller than a corresponding lateral dimension of the lower bonding pad layer. According to an embodiment, a lateral dimension of the upper bonding pad layer is larger than a corresponding lateral dimension of the lower bonding pad layer and wherein a lateral side edge of the upper bonding pad layer is aligned with a lateral side edge of the passivation layer.

### BRIEF DESCRIPTION OF THE DRAWINGS

For a better understanding of the embodiments, reference will now be made by way of example only to the accompanying figures in which:
Figure 1 is a cross-sectional view of a conventional integrated circuit;
Figure 2 is a cross-sectional view of an integrated circuit having an increased thickness;
Figures 3A-3K illustrate steps in a process for forming the bonding pads for the circuit of Figure 2;
Figures 4 and 5 are scanning electron micrograph (SEM) cross-sectional images;
Figure 6 shows an alternative embodiment; and
Figure 7 shows an alternative embodiment.

### DETAILED DESCRIPTION

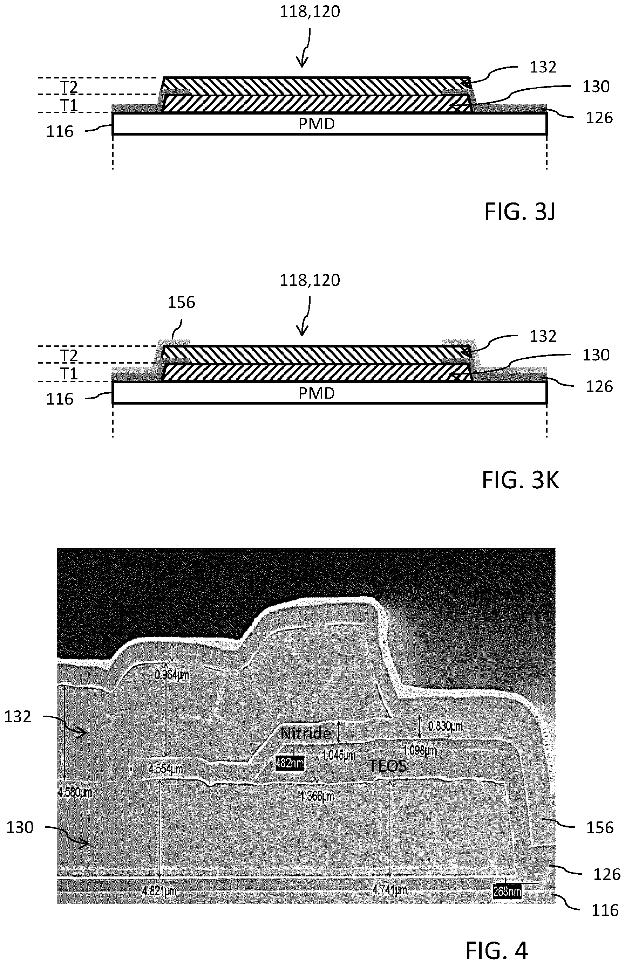

Reference is now made to Figure 2 which shows a cross-sectional view of an integrated circuit 110 which includes a semiconductor substrate 112 in and on which is formed an integrated circuit device. As an example, the integrated circuit device may comprise a vertically conducting power MOSFET device where a drain electrode 114 of the transistor is provided at the back side of the semiconductor substrate 112, a vertical gate is provided in the semiconductor substrate 112 and a doped source region is provided at an upper surface of the semiconductor substrate 12. A premetallization dielectric (PMD) layer 116 covers semiconductor substrate 112. Bonding pads 118 and 120 are provided above the premetallization dielectric layer 116 for the gate electrode 122 (electrically coupled to the vertical gate) and source electrode 124 (electrically coupled to the source region), respectively, of the transistor. The bonding pads 118 and 120 differ from the bonding pads 18 and 20 in Figure 1 in that each is formed by a stack of bonding pad layers including a lower bonding pad layer 130 with a thickness T1 and an upper bonding pad layer 132 with a thickness T2. The overall thickness T1+T2 of the bonding pads 118 and 120 is greater than the thickness T of the bonding pads 18 and 20 in Figure 1. For example, the bonding pads 118 and 120 may be twice as thick as the bonding pads 18 and 20. A passivation layer 126 covers the lower bonding pad layer 130 of the bonding pads 118 and 120, as well as the upper surface of the premetallization dielectric layer 116, and includes openings for the upper bonding pad layer 132 to make contact with the lower bonding pad layer 130. Although not explicitly illustrated here, a further passivation layer may be provided over the upper bonding pad layer 132 (see, reference 156, Figure 3K).

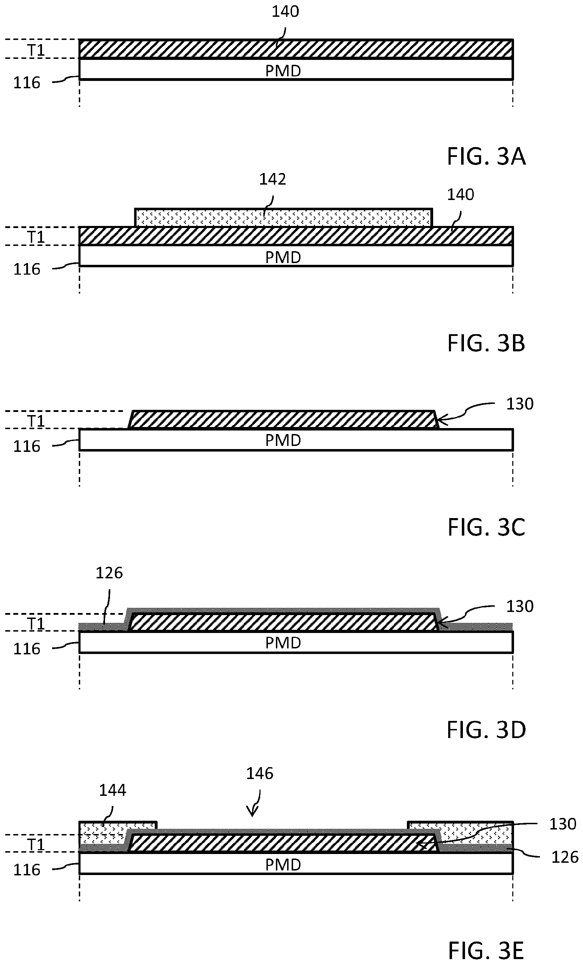

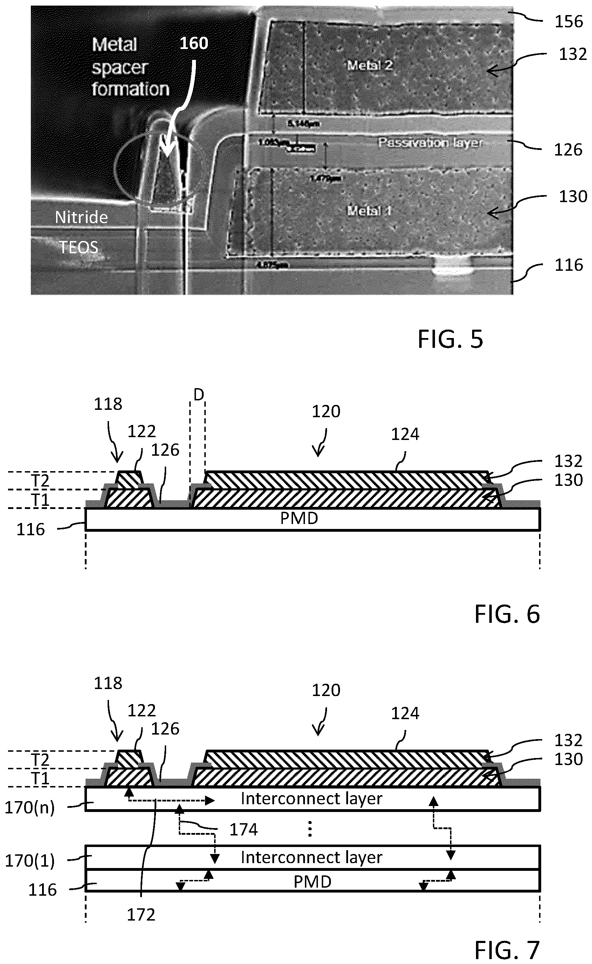

Reference is now made to Figures 3A-3J which illustrate steps in a process for forming the bonding pads 118 and 120 for the circuit of Figure 2. In Figures 3A-3J the details of the substrate are not illustrated (the existence of the substrate generally indicated by the dashed vertical lines. Furthermore, although a premetallization dielectric (PMD) layer 116 is shown, this is by way of example for the preferred embodiment where the integrated device is vertically conducting power MOSFET device. In alternative embodiments, the illustrated premetallization dielectric layer 116 may be any uppermost dielectric (or insulating) layer of an integrated circuit device (for example, the uppermost layer of a multilayer interconnect) as shown in Figure 7.

Figure 3A - deposit a first metal layer 140 with a thickness T1 over the premetallization dielectric layer 116. Although not explicitly shown, it will be noted that a barrier metal layer may be provided between the first metal layer 140 and the premetallization dielectric layer 116. The first metal layer 140 may be made of AlCu. The thickness T1 may, for example, be in a range of 4-5 µm, and more generally speaking is a large and/or maximum metal layer thickness supported by the (typical) semiconductor processes.

Figure 3B - deposit and pattern a resist layer 142 to form a mask.

Figure 3C - perform a dry etch of the first metal layer 140 using the mask to define the lower bonding pad layer 130 with the thickness T1. The mask provided by patterned resist layer 142 is then removed.

Figure 3D - conformally deposit the passivation layer 126. In an embodiment, the passivation layer 126 may be made of one or more of a nitride (SiN, for example) layer and a Tetraethyl orthosilicate (TEOS) layer. Indeed, in an embodiment the passivation layer 126 is formed by a stack of a nitride layer and a TEOS layer (see, Figure 4).

Figure 3E - deposit and pattern a resist layer 144 to form a mask with an opening 146 aligned with the lower bonding pad layer 130. It will be noted here that the resist layer 144 need only have a thickness that is 30-40% greater than the thickness of the lower bonding pad layer 130.

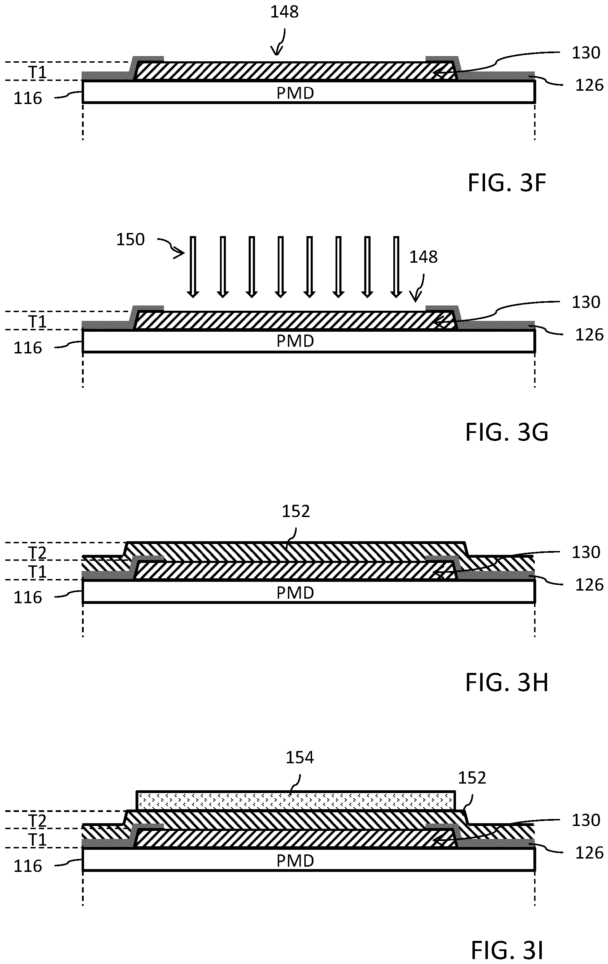

Figure 3F - perform a passivation etch to remove a portion of the passivation layer 126 which is exposed in the opening 146 and thus form a passivation opening 148 in the passivation layer 126. The mask provided by patterned resist layer 144 is then removed.

Figure 3G- perform an Argon sputter 150 to pre-condition the upper surface of the lower bonding pad layer 130 in the opening 148 and remove any metal oxide which may be present.

Figure 3H - conformally deposit a second metal layer 152 with a thickness T2 over the passivation layer 126 and the lower bonding pad layer 130 in the passivation opening 148. The deposition of the second metal layer 152 is preferably performed without use of a sputter etch in order to preclude metallic contamination of the etch chamber. The second metal layer 152 may be made of AlCu. The thickness T2 may, for example, be in a range of 4-5 µm, and more generally speaking is a large and/or maximum metal layer thickness supported by the (typical) semiconductor processes.

Figure 3I - deposit and pattern a resist layer 154 to form a mask aligned with the lower bonding pad layer 130. It will be noted here that a higher than normal exposure energy (for example, about 50% more) is needed here. This is due to the additional second metal layer 152 deposition and the high topology created in between the lower bonding pad layer 130. This area, when coated by the resist layer 154, will experience a much thicker than normal resist coverage because of the high topology effect. This thicker resist necessitates use of higher exposure energy.

Figure 3J - perform a wet etch of the second metal layer 152 using the mask to define the upper bonding pad layer 132 with the thickness T2. The mask provided by patterned resist layer 154 is then removed.

Figure 3K - using the process as shown in Figure 3D-3E, a further passivation layer 156 may be formed over the upper bonding pad layer 132. This further passivation layer 156 is optional and may, for example, be made of a nitride material.

This completes the fabrication of the bonding pad 118, 120. A scanning electron micrograph (SEM) cross-sectional image of the bonding pad as formed using the process of Figures 3A-3K is shown in Figure 4.

It is important that the etch performed in the step shown by Figure 3J is not a dry etch. The reason for this is that an anisotropic dry etch of the second metal layer 152 can create an undesired metal spacer (from the second metal layer 152) at the sidewall of the passivation layer adjacent the lower bonding pad layer 130. See, scanning electron micrograph (SEM) cross-sectional image in Figure 5 (reference 160).

Reference is now made to Figure 6 which illustrates an alternative embodiment for the bonding pads 118, 120. Controlling the patterning of the resist layer 154 in the step shown in Figure 3I allows for control to be exercised over the lateral dimensions of the upper bonding pad layer 132. Figures 2 and 3J show an implementation where the lateral dimensions of the upper bonding pad layer 132 are generally aligned with the lateral dimensions of the lower bonding pad layer 130. However, due to tolerance and masking alignment concerns, it may be advantageous to have the lateral dimensions of the upper bonding pad layer 132 be smaller than the lateral dimensions of the lower bonding pad layer 130. Figure 6 shows the provision of a lateral offset distance D that will ensure proper placement of the upper bonding pad layer 132 with little to no risk of overhang due to lateral misplacement over the lower bonding pad layer 130. The size of the lateral offset distance D can be controlled by the proper sizing of the mask formed by the resist layer 154 and the amount of overetch by the wet etch of the second metal layer 152. As an example, D may comprise a distance in a range of 5.5-6.5 µm. Although not explicitly illustrated here, a further passivation layer may be provided over the upper bonding pad layer 132 (see, reference 156, Figure 3K).

Reference is now made to Figure 7 which shows an alternative embodiment. The embodiments shown in Figures 2 and 3K, for example, show the bonding pads 118, 120 supported by a support layer or structure of the circuit 110 formed by the premetallization dielectric layer 116. In the embodiment of Figure 7, however, a plurality of interconnect layers 170(1)-170(n) are provided over the premetallization dielectric layer 116, and the bonding pads 118, 120 supported by an uppermost one of the interconnect layers 170(n) which provides the bonding pad support layer or structure. As well known to the those skilled in the art, the interconnect layers 170(1)-170(n) include conductive lines 172 and vias 174 for making electrical interconnections among the integrated circuit devices formed on and in the semiconductor substrate 112 and further between those integrated circuit devices and the bonding pads 118, 120. The process shown in Figures 3A-3K is equally applicable to forming the bonding pads 118, 120 as supported by the uppermost one of the interconnect layers 170(n) in integrated circuit designs which include one or more interconnect layers over the premetallization dielectric layer 116.

While the invention has been illustrated and described in detail in the drawings and foregoing description, such illustration and description are considered illustrative or exemplary and not restrictive; the invention is not limited to the disclosed embodiments. Other variations to the disclosed embodiments can be understood and effected by those skilled in the art in practicing the claimed invention, from a study of the drawings, the disclosure, and the appended claims.

## Claims

1. A method, comprising:
depositing a first metal layer over a bonding pad support layer;
patterning the first metal layer to define a lower bonding pad layer;
conformally depositing a passivation layer over the lower bonding pad layer;
forming a passivation opening in the passivation layer to expose a portion of an upper surface of the lower bonding pad layer;
conformally depositing a second metal layer over the passivation layer and in contact with the upper surface of the lower bonding pad layer in the passivation opening; and
patterning the second metal layer to define an upper bonding pad layer;
wherein said upper and lower bonding pad layers form a bonding pad for an integrated circuit.

2. An integrated circuit, comprising:
a bonding pad support layer;
a lower bonding pad layer over the bonding pad support layer;
a passivation layer over the lower bonding pad layer;
wherein said passivation layer includes a passivation opening at a portion of an upper surface of the lower bonding pad layer;
an upper bonding pad layer on said passivation layer and in said passivation opening in contact with the lower bonding pad layer;
wherein said upper and lower bonding pad layers are in direct contact and form a bonding pad for said integrated circuit.

3. The method of claim 1, or the circuit of claim 2, wherein the bonding pad support layer comprises a premetallization dielectric layer.

4. The method of claim 1 or 3, or the circuit of claim 2 or 3, wherein the bonding pad support layer comprises an upper most interconnect layer.

5. The method of any of claims 1, 3 and 4, or the circuit of any of claims 2 to 4, wherein the passivation layer comprises a nitride layer.

6. The method of any of claims 1, 3 to 5, or the circuit of any of claims 2 to 5, wherein the passivation layer comprises a Tetraethyl orthosilicate (TEOS) layer.

7. The method of any of claims 1, 3 to 6, or the circuit of any of claims 2 to 6, wherein the passivation layer comprises stack including a nitride layer and a Tetraethyl orthosilicate (TEOS) layer.

8. The method of any of claims 1, 3 to 7, further comprising, after forming the passivation opening and before conformally depositing the second metal layer, performing an Argon sputter to pre-condition the upper surface of the lower bonding pad layer in the passivation opening.

9. The method of claim 8, wherein pre-conditioning the upper surface removes metal oxide from the upper surface.

10. The method of any of claims 1; 3 to 9, wherein conformally depositing the second metal layer is performed in the absence of a sputter etch.

11. The method of any of claims 1, 3 to 10, further comprising providing, or the circuit of any of claims 2 to 7 further comprising, a further passivation layer on the upper bonding pad layer ,.

12. The method of any of claims 1, 3 to 11, wherein patterning the first metal layer comprises performing a dry etching.

13. The method of any of claims 1, 3 to 12, wherein patterning the second metal layer comprises performing a wet etching.

14. The method of any of claims 1, 3 to 13, or the circuit of any of claims 2 to 13, wherein a thickness of the lower bonding pad layer is in a range of 4-5 µm and wherein a thickness of the upper bonding pad layer is in a range of 4-5 µm.

15. The method of any of claims 1, 3 to 14, or the circuit of any of claims 2 to 14, wherein a lateral dimension of the upper bonding pad layer is smaller than a corresponding lateral dimension of the lower bonding pad layer.

16. The method of any of claims 1, 3 to 15, or the circuit of any of claims 2 to 15, wherein a lateral dimension of the upper bonding pad layer is larger than a corresponding lateral dimension of the lower bonding pad layer and wherein a lateral side edge of the upper bonding pad layer is aligned with a lateral side edge of the passivation layer.

17. The method of any of claims 1, 3 to 16, wherein forming the passivation opening comprises:
depositing a resist layer having a thickness that is greater than a thickness of the lower bonding pad layer;
forming an opening in the resist layer to form a mask; and
performing an etch of the passivation layer through the opening in the resist layer to provide the passivation opening.
